Europäisches Patentamt

European Patent Office

Office européen des brevets

(19)

(11) Veröffentlichungsnummer: **0 135 137**
**A2**

(12) ## EUROPÄISCHE PATENTANMELDUNG

(21) Anmeldenummer: **84109636.5**

(22) Anmeldetag: **13.08.84**

(51) Int. Cl.⁴: **H 01 L 29/08**
**G 11 C 11/40**

(30) Priorität: **19.08.83 DE 3330013**

(43) Veröffentlichungstag der Anmeldung:
**27.03.85 Patentblatt 85/13**

(84) Benannte Vertragsstaaten:
**AT DE FR GB IT NL**

(71) Anmelder: **Siemens Aktiengesellschaft**
**Berlin und München Wittelsbacherplatz 2**
**D-8000 München 2(DE)**

(72) Erfinder: **Schmitt-Landsiedel, Doris, Dipl.-Ing.,**
**Dipl.-Phys.**
**Metzstrasse 25**
**D-8000 München 80(DE)**

(72) Erfinder: **Dorda, Gerhard, Dr.**
**Triester Strasse 11**
**D-8000 München 80(DE)**

(54) **Statische Speicherzelle.**

(57) Statische Speicherzelle mit zwei kreuzgekoppelten Invertern, die jeweils aus einem Feldeffekttransistor (T1, T2) und einem zu diesem in Serie geschalteten Widerstandselement (R1, R2) bestehen. Dabei ist jeder Schaltungsknoten (3, 5) über ein zusätzliches Schaltelement mit einer zugeordneten Bitleitung (BL, $\overline{BL}$) beschaltet. Angestrebt wird die Realisierung der Speicherzelle auf einer möglichst kleinen Halbleiterfläche und eine kurze Zugriffszeit. Erreicht wird das durch die Ausbildung der zusätzlichen Schaltelemente als Heiße-Elektronen-Transistoren, die jeweils mit einem der Feldeffekttransistoren zu einem gemeinsamen Bauelement zusammengefaßt werdne, das nur die Fläche eines Feldeffekttransistors benötigt. Der Anwendungsbereich umfaßt hochintegrierte Halbleiterspeicher.

FIG 1

EP 0 135 137 A2

SIEMENS AKTIENGESELLSCHAFT     Unser Zeichen
Berlin und München             VPA   83 P 1610 E

## Statische Speicherzelle

Die Erfindung bezieht sich auf eine statische Speicherzelle nach dem Oberbegriff des Patentanspruchs 1.

Eine solche Speicherzelle ist aus dem Buch
"Elektronische Schaltkreise" von A. Möschwitzer und
G. Jorke, VEB Verlag Technik, Berlin, 1979, S. 141,
Bild 2.76c, bekannt. Die zusätzlichen Schaltelemente
sind hier als Feldeffekttransistoren realisiert, über
deren Source-Drain-Strecken die Schaltungsknoten mit
jeweils einer Bitleitung verbunden sind.

Der Erfindung liegt die Aufgabe zugrunde, eine statische
Speicherzelle der eingangs genannten Art anzugeben, die
auf einer wesentlich kleineren Halbleiterfläche realisiert werden kann, als vergleichebare herkömmliche Speicherzellen. Erfindungsgemäß wird dies durch eine Ausbildung nach dem kennzeichnenden Teil des Patentanspruchs 1 erreicht.

Der mit der Erfindung erzielbare Vorteil besteht insbesondere darin, daß jeweils zwei Transistoren der oben
erwähnten, bekannten Speicherzelle zu einem einzigen
Halbleiterbauelement zusammengefaßt werden, das zwei
Transistorfunktionen übernimmt und zur Realisierung
lediglich die Halbleiterfläche eines einzigen MIS-
Feldeffekttransistors benötigt. Die Zugriffszeit für die
Speicherzelle nach der Erfindung ist gegenüber herkömmlichen Speicherzellen wesentlich verkürzt, da die
verwendeten Heiße-Elektronen-Transistoren schnellschal-

St 1 Sti/18.8.1983

tende Elemente darstellen und die Verbindungsleitungen
zwischen den jeweils zu den Bauelementen zusammengefaßten Transistoren entfallen.

Die Anspruüche 2 bis 9 sind auf bevorzugte Ausgestaltungen und Weiterbildungen der Erfindung gerichtet.

Nachfolgend wird die Erfindung anhand der Zeichnung
näher erläutert. Dabei zeigt:

Fig. 1 eine nach der Erfindung ausgebildete statische
       Speicherzelle,

Fig. 2 den Querschnitt eines in Fig. 1 schematisch dargestellten Bauelements, das einen MIS-Feldeffekttransistor und einen Heiße-Elektronen-
       Transistor umfaßt, und

Fig. 3 ein Bandstrukturschema zur Erläuterung von
       Fig. 2.

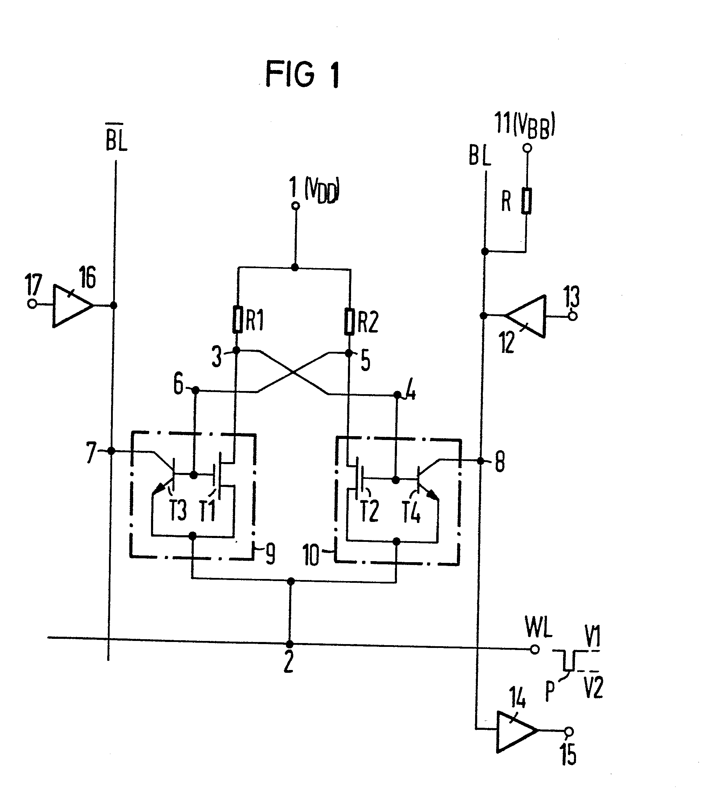

In Fig. 1 sind zwei kreuzgekoppelte Inverter dargestellt, die eine Flipflop-Schaltung bilden. Der
erste Inverter besteht aus der Serienschaltung eines
Feldeffekttransistors T1 und eines Widerstandselements
R1, die mit endseitigen Anschlüssen 1 und 2 versehen
ist. Dabei ist der Anschluß 1 mit einer Versorgungsspannung $V_{DD}$ beschaltet, während der Anschluß 2 mit
einer Wortleitung WL verbunden ist, die zur Adressierung
der Speicherzelle dient. Der zweite Inverter, der aus
der Serienschaltung eines Feldeffekttransistors T2 und
eines Widerstandselements R2 besteht, liegt ebenfalls an
den Anschlüssen 1 und 2. Zwischen T1 und R1 liegt ein
Schaltungsknoten 3, der mit dem Gateanschluß 4 von T2
verbunden ist, zwischen T2 und R2 ein Schaltungs-

knoten 5, der an den Gateanschluß von T1 geführt ist.
Die Widerstandselemente R1 und R2 können als Feldeffekttransistoren des Verarmungstyps ausgebildet sein,
deren Gateanschlüsse mit den Sourceanschlüssen verbunden sind, oder als Feldeffekttransistoren des Anreicherungstyps, deren Gateanschlüsse mit den Drainanschlüssen verbunden sind, oder auch als streifenförmige Strukturen aus widerstandsbehaftetem Material
oder dgl..

Mit T3 ist ein Heiße-Elektronen-Transistor des Tunnelemissionstyps bezeichnet, dessen Basisanschluß mit dem
Gateanschluß von T1 zusammenfällt. Er weist einen
Kollektoranschluß 7 auf, der mit einer Bitleitung $\overline{BL}$
beschaltet ist, während sein Emitter mit dem Anschluß 2
verbunden ist. Ein anderer Heiße-Elektronen-Transistor
des Tunnelemissionstyps ist mit T4 bezeichnet. Dieser
ist mit einem Basisanschluß versehen, der mit dem Gateanschluß von T2 zusammenfällt, sowie mit einem Kollektoranschluß 8, der mit einer Bitleitung BL beschaltet
ist. Sein Emitter ist ebenfalls an den Anschluß 2
geführt. Heiße-Elektronen-Transistoren sind z.B. aus
"Solid-State Electronics", Bd. 24, 1981, S. 343 - 366,
insbesondere Fig. 1 bekannt.

Die Transistoren T1 und T3 sind zu einem gemeinsamen
Bauelement 9 zusammengefaßt, wie in Figur 1 angedeutet
ist, die Transistoren T2 und T4 zu einem gemeinsamen
Bauelement 10. Die Bitleitung BL ist über ein Widerstandselement R mit einer Spannung $V_{BB}$ beschaltet, die
einem Anschluß 11 zugeführt wird. Weiterhin ist BL mit
dem Ausgang eines Schreibverstärkers 12 verbunden,
dessen Eingang mit 13 bezeichnet ist, sowie mit dem
Eingang eines Leseverstärkers 14, der einen Ausgang 15
besitzt. Die Bitleitung $\overline{BL}$ ist mit dem Ausgang eines
Schreibverstärkers 16 verbunden, der einen Eingang 17
aufweist.

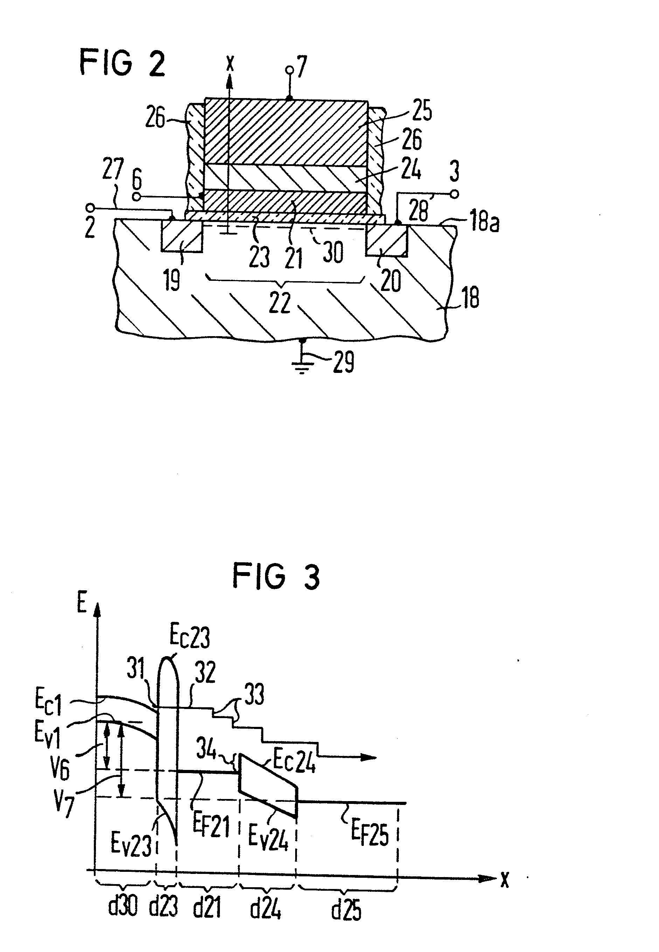

Die in Fig. 1 schematisch dargestellten, gleichartig aufgebauten Bauelemente 9 und 10 werden nachfolgend anhand des in Fig. 2 dargestellten Bauelements 9 näher beschrieben.

Es ist auf einem Körper 18 aus dotiertem Halbleitermaterial, z.B. aus p-dotiertem Silizium mit einer Störstellenkonzentration von etwa $10^{15}/cm^3$, angeordnet, in den zwei von einer Grenzfläche 18a ausgehende, z.B. n+-dotierte, Gebiete 19 und 20 eingefügt sind. Diese stellen das Sourcegebiet und das Draingebiet eines Feldeffekttransistors dar, dessen Gateelektroden aus einer metallischen bzw. metallisch leitenden Schicht 21 gebildet ist, die den zwischen 19 und 20 liegenden Kanalbereich 22 überdeckt. Zwischen der Schicht 21 und der Grenzfläche 18a liegt dabei eine sehr dünne Isolatorschciht 23. Die Dicke der z.B. aus $SiO_2$ oder $Si_3N_4$ bestehenden Isolatorschicht 23 beträgt zweckmäßigerweise etwa 2 bis 5 nm. Die Schicht 21 besteht mit Vorteil aus einem hochschmelzenden Metall, z.B. aus Ta, Ti oder Mo oder W, oder aus dem Silizid eines dieser Metalle, d.h. $TaSi_2$, $TiSi_2$, $MoSi_2$ oder $WSi_2$, und kann eine Dicke von etwa 10 nm aufweisen. Oberhalb der metallischen Schicht 21 befindet sich eine polykristalline Siliziumschicht 24 mit einer Dicke von etwa 10 bis 100 nm und vorzugsweise mit einer p-Dotierung, die etwa durch eine Dotierungskonzentration von $10^{14}$ bis $10^{15}/cm^3$ gegeben ist, wobei als Dotierstoff Bor herangezogen werden kann. Auf der Schicht 24 befindet sich eine metallische bzw. metallisch leitende Schicht 25, deren Dicke beliebig gewählt sein kann, zweckmäßigerweise jedoch größer ist als die Schichtdicke von 24. Die Schicht 25 besteht dabei mit Vorteil aus einem der Metalle oder Silizide, die bereits im Zusammenhang mit der Schicht 21 genannt worden sind. Eine die Oberfläche 18a außerhalb der Teile 19, 20 und 22 abdeckende elektrisch isolierende Schicht (Feldoxidschicht) weist an die Schichten 21, 24 und 25 lateral angrenzende Teile 26 auf.

Das Sourcegebiet 19 und das Draingebiet 20 sind mit Anschlußleitungen 27, 28 versehen, die mit den Schaltungspunkten 2 und 3 verbunden sind. Die metallische Schicht 21 ist mit dem Anschluß 6 (Fig. 1) versehen. Weiterhin ist der Halbleiterkörper 18 über einen Anschluß 29 auf Massepotential gelegt. Die metallische Schicht 25 ist schließlich mit dem Schaltungspunkt 7 verbunden.

Erhält die aus der Schicht 21 bestehende Gateelektrode des Feldeffekttransistors über den Anschluß 6 eine Spannung zugeführt, die oberhalb eines als erste Einsatzspannung bezeichneten Wertes liegt, so bildet sich im Halbleiterkörper 18 unterhalb von 21 eine von der Grenzfläche 18a ausgehende Verarmungszone zwischen den Gebieten 19 und 20 aus, wobei sich innerhalb dieser Verarmungszone unmittelbar an der Grenzfläche 18a eine Inversionsschciht 30 aufbaut, die einen n-leitenden Kanal zwischen den Gebieten 19 und 20 bildet.

Die Inversionsschicht 30 stellt die Emitterschicht eines Heiße-Elektronen-Transistors (HET) des Tunnelemissionstyps dar, der zusätzlich die Schichten 23, 21, 24 und 25 aufweist. Dabei bildet die Schicht 21 eine metallische Basisschicht des HET, wobei sich die Isolatorschicht 23 zwischen der Schicht 21 und der Emitterschicht 30 befindet, während die polykristalline Siliziumschicht 24 zusammen mit der metallischen Schicht 25 die Kollektorschicht des HET darstellt.

Die Funktion des HET sei nachfolgend anhand des in Fig. 2 dargestellten energetischen Bandstrukturschemas erläutert. Dieses zeigt in Richtung der vertikalen Achse auf-

0135137

getragene Energiezustände E, die in Abhängigkeit von
verschiedenen Entfernungen x von der Inversionsschicht
bzw. Emitterschicht 30 auftreten. Diese Entfernungen
sind auf einer Achse x aufgetragen, die in Fig. 1 die
Schichten des HET in vertikaler Richtung, d.h. senkrecht
zur Grenzfläche 18a, durchdringt. Den Schichten 30, 23,
21, 24 und 25 sind aufeinanderfolgende Abschnitte der
x-Achse zugeordnet, wobei aus Gründen einer deutlichen
Darstellung die Längen d30, d23, d21, d24 und d25 dieser
Abschnitte von den tatsächlichen Schichtdicken D30, D23,
D21, D24 und D25 der Schichten 30, 23, 21, 24 und 25 abweichen. So ist z.B. der Abschnitt d23 gegenüber den Abschnitten d30, d21, d24 und d25 stark gedehnt. In dem
der Inversionsschicht 30 zugeordneten Abschnit d30 ist
die obere Grenze des Valenzbandes des Halbleitermaterials
von 18 mit $E_{v1}$ bezeichnet, während $E_{c1}$ das Energieniveau
der Elektronen innerhalb der Inversionsschicht 30 darstellt. Im Abschnitt d23 stellt die obere Linie $E_{c23}$
die untere Begrenzung des Leitungsbandes der Isolatorschicht 23 dar, während die untere Linie $E_{v23}$ die obere
Grenze des Valenzbandes bedeutet. In den Abschnitten d21
und d25 sind die jeweiligen Fermi-Niveaus $E_{F21}$ und $E_{F25}$
eingetragen, während im Abschnitt d24 die untere Grenze
des Leitungsbandes der Schicht 24 durch $E_{c24}$ und die
obere Grenze des Valenzbandes durch $E_{v24}$ dargestellt
werden. Bei einer hinreichend kleinen Dicke D23 der
Isolatorschicht 23 gelangen Elektronen aus der Inversionsschicht 30, die in Fig. 3 gemäß ihrem Energieniveau
z.B. durch den Punkt 31 gekennzeichnet sind, infolge des
Tunneleffekts durch die Isolatorschicht 23, in die
metallische Basisschicht 21, wie durch die horizontale
Gerade 32 angedeutet wird. Durch Streuung an Fehlstellen
und am Kristallgitter der Schicht 21 verlieren sie an
Energie, was durch den treppenförmigen Verlauf 33 ausgedrückt wird. Ist die Energie dieser Elektronen danach
noch so groß, daß sie die Energieschwelle 34 an der Grenzfläche zwischen den Schichten 21 und 24 überwinden können, so gelangen sie in die aus den Schichten 24 und 25 bestehende Kollektorschicht des HET. Die Größe der über die Anschlüsse 6 und 7 zugeführten Spannungen $V_6$ und $V_7$ ist in Fig. 3 ebenfalls eingezeichnet.

Das Bauelement 10 ist entsprechend aufgebaut und gemäß Fig. 1 mit den Anschlüssen 2, 4, 5 und 8 versehen.

Bei der Betrachtung der Wirkungsweise der Schaltung nach Fig. 1 wird davon ausgegangen, daß in der Speicherzelle eine logische "1" gespeichert ist, wenn sich das Flipflop in dem Zustand befindet, in dem T1 leitet und T2 sperrt. Das bedeutet, daß die Schaltunspunkte 5 und 6 auf einem höheren Potential liegen als die Schaltungspunkte 3 und 4. Dabei ist weiterhin neben dem linken Schaltungszweig des Flipflops, der sich von 1 über R1, 3 und T1 zum Anschluß 2 erstreckt, noch ein zweiter Schaltungszweig durchflossen, der von 1 über R2, 5 und die Basis-Emitter-Strecke von T3 nach 2 verläuft. In diesem Zweig fließt ein Tunnelstrom, der durch eine die Einsatzspannung von T1 übersteigende Spannung am Anschluß 6 bezogen auf das Potential auf der Wortleitung WL ausgelöst wird und zwischen der Basisschicht 21 und der Emitterschicht 30 von T3 fließt. Neben T2 ist auch T4 gesperrt, weil sich das niedrige Potential des Anschlusses 4 bzw. der Basisschicht 21 von T4 wegen des leitenden Transistors T1 praktisch nicht von dem Potential der Emitterschicht 30 von T4 bzw. vom Potential der Wortleitung WL unterscheidet.

Beim Lesen eines gespeicherten Signals wird zunächst die betreffende Zelle adressiert, was durch das Absenken des Potentials auf der zugeordneten Wortleitung WL von einem Wert V1, der etwa $V_{DD}/2$ entspricht, auf einen dem Bezugspotential entsprechenden Wert V2 geschieht. Außerdem wird dem Anschluß 11 eine Spannung $V_{BB}$ zugeführt, die z.B. ebenfalls $V_{DD}/2$ beträgt. Für die selektierte Speicherzelle liegt dann zwischen dem Kollektor und dem Emitter von T4 eine Spannung $V_7$ (Fig. 3), zwischen der Basis und dem Emitter jedoch wegen des leitenden Transistors T1 praktisch keine Spannung. Damit bleibt T4 gesperrt, so daß das Potential am Eingang von 14 etwa $V_{BB}$ entspricht, wobei am Ausgang 15 eine logische "1" auftritt.

Ist eine logische "0" eingespeichert, so sperrt T1, während T2 leitet. Dabei liegen an den Punkten 3 und 4 wesentlich höhere Potentiale als an den Punkten 5 und 6. Wird in diesem Fall ausgelesen, so wird neben der dem Kollektoranschluß 8 über 11 zugeführten Spannung $V_{BB}$ über den Anschluß 4 eine auf das Bezugspotential V2 bezogene Spannung $V_6$ (Fig. 3) an die Basisschicht 21 von T4 angelegt. Damit fließt im Schaltzweig 11, R, 8, T4 und 2 ein Strom, der von dem zwischen den Schichten 30 und 21 von T4 vorhandenen Tunnelstrom abhängt. Hierbei entsteht ein Spannungsabfall an R, um den das Potential am Eingang von 14 gegenüber $V_{BB}$ verringert wird, so daß am Ausgang 15 eine logische "0" abgreifbar ist.

Zum Einschreiben einer "0" in eine Speicherzelle wird über den Eingang 13 des Schreibverstärkers 12 eine Spannung zugeführt, die die Bitleitung BL auf ein Potential legt, das zwischen $V_1$ und $V_{DD}$ liegt oder $V_{DD}$ übersteigt. Da der Anschluß 4 bzw. die Basisschicht 21 von T4 unter der Voraussetzung, daß vorher eine "1" eingespeichert war, auf einem Potential liegt, das etwa dem Potential von WL entspricht, welches aber bei der Adressierung der Zelle auf $V_2$ abgesenkt wurde, liegt an der Kollektor-Basisstrecke von T4 eine Spannung solcher Größe, daß durch die Schicht 24 ein Tunnelstrom fließt.

0135137
83 P 1 6 1 0 E

Ein von diesem abhängiger Strom durchfließt dann den Schaltzweig 13, 12, 8, die Kollektor-Basis-Strecke von T4, 4, 3, T1 und 2, wobei am Bahnwiderstand von T1 ein solcher Spannungsabfall entsteht, daß das Potential am Schaltungspunkt 4 angehoben wird. Dadurch wird T2 leitend, was zur Folge hat, daß T1 sperrt. Damit ist eine "0" in die Speicherzelle eingeschrieben. Wenn vorher bereits eine "0" eingespeichert war, so liegt an 4 ein so hohes Potential, daß die über 12 erfolgende Potentialanhebung von BL nicht ausreicht, um einen Tunnelstrom zwischen Kollektor und Basis von T4 herbeizuführen.

Entsprechende Vorgänge laufen beim Einschreiben einer "1" ab, wobei in diesem Fall die Bitleitung $\overline{BL}$ mittels einer dem Eingang 17 des Schreibverstärkers 16 zugeführten Spannung auf ein Potential angehoben wird, das zwischen $V_1$ und $V_{DD}$ liegt oder $V_{DD}$ übersteigt. War vorher eine "0" eingeschrieben, so wird der Stromzweig 17, 16, 7, KollektorBasis-Strecke von T3, 6, 5, T2 und 2 von einem Strom durchflossen, durch den das Potential am Schaltungspunkt 6 so weit angehoben wird, daß T1 leitend wird, und T2 sperrt.

Wie bereits beschrieben, erfolgt das Selektieren einer Speicherzelle durch ein kurzzeitiges Absenken des Potentials auf der Wortleitung WL, an der die Zelle liegt, was durch den Impuls P gekennzeichnet ist. Nach dem Einschreiben oder Auslesen wird dann das Potential auf BL wieder auf $V_1$ angehoben. Dadurch wird verhindert, daß beim Einschreiben in andere Speicherzellen, die zusammen mit der betrachteten Speicherzelle an gemeinsamen Bitleitungen BL und $\overline{BL}$ liegen, eine Verfälschung des in die betrachtete Speicherzelle eingeschriebenen Signals erfolgt.

Das Potential, auf das BL während eines Schreibvorgangs angehoben wird, muß sich von V1 um einen Betrag unterscheiden, der kleiner ist als die kritische Spannung, bei der ein Tunnelstrom zwischen Kollektor und Basis von T4 zu fließen beginnt. Diese Bedingung muß eingehalten werden, um eine Verfälschung eingespeicherter Signale durch Einschreibvorgänge an nichtadressierten Zellen zu vermeiden. Weiterhin muß sich das Potential am Schaltungspunkt 4 einer nichtadressierten Zelle, in die eine "0" eingeschrieben ist, von dem Potential, auf das die Bitleitung BL beim Lesen einer "0" aus einer anderen an BL liegenden Zelle abgesenkt wird, um einen Betrag unterscheiden, der kleiner ist als die genannte kritische Spannung.

Nach einer anderen bevorzugten Ausführungsform der Erfindung ist das Halbleiterbauelement 9 oder 10 auf einem Körper 18 aus einer p-dotierten III-V-Halbleiterverbindung, z.B. GaAs mit einer Dotierungskonzentration von z.B. $10^{16}/cm^3$, aufgebaut, wobei die Isolatorschicht 23 zweckmäßigerweise aus AlGaAs besteht. An die Stelle der polykristallinen Siliziumschicht 24 tritt hier eine Schicht aus p-dotiertem GaAs mit Be als Dotierstoff, während die Schicht 21 vorzugsweise aus einer hochdotierten n-leitenden III-V-Halbleiterverbindung, z.B. GaAs mit Si als Dotierstoff, gebildet wird, die sich bei einer Dotierungskonzentration von etwa $10^{18}/cm^3$ hinsichtlich ihrer elektrischen Leitfähigkeit ähnlich wie ein Metall verhält. Die Schicht 25 besteht auch hierbei mit Vorteil aus dem gleichen Material wie die Schicht 21.

Bei einer weiteren Ausführungsform der Erfindugn ist das Halbleiter-Bauelement 9 oder 10 so ausgebildet, daß an die Stelle der bisher beschriebenen Schicht 24 eine zweite Isolatorschicht tritt, die in ihrem Aufbau und in ihrer Dicke vorzugsweise der Isolatorschicht 23 entspricht. Für den Fall, daß ein Halbleiterkörper 18 aus p-dotiertem Silizium vorgesehen ist, besteht die zweite Isolatorschicht aus $SiO_2$ oder $Si_3N_4$. Bei einem Halbleiterkörper aus GaAs besteht sie aus AlGaAs. Ihre Dicke beträgt zweckmäßigerweise etwa 2 bis 5 nm.

Die Herstellung der Halbleiter-Bauelements nach Fig. 2 entspricht zunächst der üblichen Herstellung eines Feldeffekttransistors. Nachdem eine den z.B. aus dotiertem Silizium bestehenden Halbleiterkörper ganzflächig bedeckende Feldoxidschicht 26 oberhalb des Kanalbereichs 22 und oberhalb der Gebiete 19 und 20 weggeätzt und in dem weggeätzten Bereich eine Isolatorschicht 23 thermisch aufgewachsen worden ist, wird eine großflächige Maske auf der so entstandenen Struktur angebracht, die eine die lateralen Abmessungen der Schichten 21, 24 und 25 definierende Öffnung enthält. Unter Anwendung dieser Maske werden dann die Schichten 21, 24 und 25 nacheinander aufgebracht. Dabei wird die Polysiliziumschicht 24 nach dem Aufbringen gegebenenfalls mit einer p-Dotierung versehen, deren Konzentration $10^{14}$ bis $10^{15}/cm^3$ beträgt, bevor die Schicht 25 aufgebracht wird. Nach dem Entfernen der Maske erfolgt eine Implantation eines Dotierstoffes zur Erzeugung der Gebiete 19 und 20, wobei die Schichten 21, 24 und 25 sowie die Feldoxidschicht als Teile einer Dotierungsmaske dienen (Selbstjustierung). Nach dem Anbringen der Anschlußleitungen 27 und 28, die die Teile 19 und 20 durch Kontaktlöcher in der Isolatorschicht 23 kontaktieren, werden schließlich oberhalb der Gebiete 19 und 20 die vorher weggeätzten Teile der Feldoxidschicht wieder so weit aufgebaut, daß die Feldoxidschicht an die lateralen Begrenzungsflächen der Schichten 21, 24 und 25 heranreicht, wie das in Fig. 2 ddurch die Teile 26 angedeutet ist. Danach wird eine weitere Anschlußleitung

0135137
83 P 1 6 1 0 E

verlegt, die die Schicht 25 kontaktiert und mit dem Anschluß 7 versehen ist.

9 Patentansprüche
3 Figuren

Patentansprüche

1. Statische Speicherzelle mit zwei kreuzgekoppelten Invertern, die jeweils aus einem Feldeffekttransistor (T1, T2) und einem zu diesem in Serie geschalteten Widerstandselement (R1, R2) bestehen, wobei der Schaltungsknoten (3) zwischen dem Feldeffekttransistor (T1) und dem Widerstandselement (R1) des einen Inverters mit dem Gateanschluß (4) des Feldeffekttransistors (T2) des anderen Inverters verbunden ist und wobei jeder Schaltungsknoten (3, 5) über ein zusätzliches Schaltelement mit einer ihm zugeordneten Bitleitung (BL, $\overline{BL}$) beschaltet ist, d a d u r c h   g e k e n n z e i c h - n e t , daß die zusätzlichen Schaltelemente jeweils aus einem Heiße-Elektronen-Transistor des Tunnelemisionstyps (T3, T4) bestehen, der eine Emitterschicht, eine Isolatorschicht, eine Basisschicht und eine Kollektorschicht aufweist, daß jeder Heiße-Elektronen-Transistor (T3) mit dem Feldeffekttransistor (T1), dessen Gateanschluß mit dem zugeordneten Schaltungsknoten (5) verbunden ist, derart zusammengefaßt ist, daß die Emitterschicht aus einer Inversionsschicht (30) im Kanalbereich (22) des Feldeffekttransistors (T1) besteht, daß die Basisschicht (21) dessen Gateelektrode darstellt, daß die Isolatorschicht (23) zwischen der Basisschicht (21) und dem Kanalbereich (22) angeordnet ist, daß die Kollektorschicht (24, 25) einen Anschluß (7) aufweist, der mit der zugeordneten Bitleitung ($\overline{BL}$) beschaltet ist und daß die Sourceanschlüsse (2) der Feldeffekttransistoren (T1, T2) mit einer zur Adressierung dienenden Wortleitung (WL) verbunden sind.

2. Statische Speicherzelle nach Anspruch 1, d a - d u r c h   g e k e n n z e i c h n e t , daß die Basisschicht (21) aus einem Metall besteht, das insbesondere einer Gruppe von hochschmelzenden Meetallen
angehört, in der Ta, Ti, Mo und W enthalten sind, oder
aus einem Silizid eines solchen Metalls.

3. Statische Speicherzelle nach Anspruch 1, d a -
d u r c h   g e k e n n z e i c h n e t , daß die
Basisschicht (21) aus einer hochdotierten III-V-Halbleiterverbindung, wiw z.B. GaAs, besteht, die mit einer
n-Dotierung versehen ist.

4. Statische Speicherzelle nach Anspruch 1, d a -
d u r c h   g e k e n n n z e i c h n e t , daß die
Kolletorschicht aus einer metallischen oder metallisch
leitenden Schicht (25)und einer zwischen dieser und der
Basisschicht (21) befindlichen, polykristallinen, vorzugsweise mit einer p-Dotierung versehenen Siliziumschicht (24) besteht.

5. Statische Speicherzelle nach Anspruch 1, d a -
d u r c h   g e k e n n z e i c h n e t , daß die
Kollektorschciht aus einer metallischen oder metallisch leitenden Schicht (25) und einer zwischen dieser
und der Basisschicht (21) befindlichen Schicht (24) aus
einer III-V-Halbleiterverbindung, wie z.B. GaAs,
besteht, die vorzugsweise mit einer p-Dotierung versehen ist.

6. Statische Speicherzelle nach Anspruch 1, daß die
Kollektorschicht aus einer metallischen oder metallisch
leitenden Schicht (25) und einer zwischen dieser und der
Basisschicht (21) befindlichen zweiten Isolatorschicht
(24) besteht.

7. Statische Speicherzelle nach einem der Ansprüche 4
bis 6, d a d u r c h   g e k e n n z e i c h n e t ,
daß die einen Teil der Kollektorschicht darstellende metallische oder metallisch leitende Schicht (25) aus einem Metall besteht, das insbesondere einer Gruppe von hochschmelzenden Metallen angehört, in der Ta, Ti, Mo und W enthalten sind, oder aus einem Silizid eines solchen Metalls.

8. Statische Speicherzelle nach einem der Ansprüche 4 bis 6, d a d u r c h  g e k e n n z e i c h n e t , daß die einen Teil der Kollektorschicht darstellende metallische oder metallisch leitende Schicht (25) aus einer hochdotierten III-V-Halbleiterverbindung, wie z.B. GaAs, besteht, die mit einer n-Dotierung versehen ist.

9. Statische Speicherzelle nach einem der Ansprüche 1 bis 8, d a d u r c h  g e k e n n z e i c h n e t , daß die Dicke der zwischen der Basisschicht (21) und dem Kanalbereich (22) befindlichen Isolatorschicht (23) und gegebenenfalls die Dicke der zweiten Isolatorschicht (24) etwa 2 bis 5 nm beträgt.

FIG 1

0135137

## FIG 2

## FIG 3